# EUROPEAN PATENT APPLICATION

(11) **EP 2 605 629 A2**
(43) Date of publication of application: **19.06.2013**
(21) Application number: 12196832.5
(22) Date of filing: 12.12.2012
(51) Int. Cl.: H05K 9/00

(54) **Shielding system for mobile device and method for assembling the system**

(30) Priority: 16.12.2011 KR 20110136348
(71) Applicant: Samsung Electronics Co., Ltd, Gyeonggi-do 443-742 (KR)
(72) Inventor: Kim, Jeongung, 443-742 Gyeonggi-do (KR); Jeong, Jaewoo, deceased (KR); Kim, Kuntak, 443-742 Gyeonggi-do (KR); Han, Hyunjoo, 443-742 Gyeonggi-do (KR); Jang, Seyoung, 443-742 Gyeonggi-do (KR)
(74) Representative: Harrison Goddard Foote LLP

(57) **Abstract**

A shielding system for a mobile device and a method for assembling the system are provided. The shielding system includes a Printed Circuit Board (PCB), and a shield enclosure coupled to a front side of the PCB and arranged to surround components on the PCB. The shield enclosure is coupled to at least one of a lateral side and a back side of the PCB.

## Description

### BACKGROUND OF THE INVENTION

### Field of the Invention:

The present invention relates to a shielding system for a mobile device. More particularly, the present invention relates to a shielding system that can be easily installed on a Printed Circuit Board (PCB) of a mobile device for increasing the stiffness of the PCB, without causing pressure to applied to the PCB, and a method for assembling the shielding system.

### Description of the Related Art:

As technology for mobile devices continues to be developed, the number of users of such mobile devices continues to increase. That is, because mobile devices provide a mobile communication function, as well as various additional functions based on the convergence of technologies, mobile devices are commonly used. Moreover, mobile devices continue to be developed to provide a variety of advanced functions to meet users' needs. To this end, they are equipped with a variety of hardware components.

Mobile devices of the related art integrate hardware components onto a PCB. For example, a mobile device integrates a communication chip for supporting a mobile communication function and a process chip for supporting a multimedia function onto one PCB. The PCB may also include a processing chip for supporting a touch screen function, and various modules for supporting a number of user functions, such as a broadcast receiving module, a short-range communication module, etc. However, when the hardware components perform switching operations to process data, they cause noise. Such noise affects the nearby processing chips. In order to address the noise that occurs when the chips operate, such as while they support a communication function, the PCB of the related art is partially covered with a conductive shield enclosure. Such a conductive shield enclosure is intended to prevent the propagation of noise and to provide stiffness to the PCB.

Shield enclosures of the related art are fixed onto PCBs via mechanical members, such as screws. To this end, a PCB includes coupling areas that allows the PCB to be coupled with the shield enclosure by a mechanical means such as a screw. The shield enclosure is placed on the PCB and then fixed thereon as screws are coupled to the coupling areas. However, since there is a constant demand for mobile devices to be thinner and to be equipped with additional hardware components, it is difficult to maintain sufficient space for the shield enclosure. In addition, shield enclosures of the related art that are fixed to PCBs via a screw coupling system are disadvantageous in that they come off the PCBs, provide only a small number of coupling space areas due to the volume limitation of mobile devices, and thus cannot provide a sufficient level of stiffness to adequately support the mobile device.

Accordingly, there is a need for an improved shielding system that is easily installed on a PCB of a mobile device and that can secure space and increase stiffness of the mobile device.

### SUMMARY OF THE INVENTION

It is an aim of certain embodiments of the present invention to address at least some of the above-mentioned problems, and/or disadvantages and to provide at least some of the advantages described below. Accordingly, an aim of certain embodiments of the present invention is to provide a shielding system, including a shielding enclosure that is easily installed on a Printed Circuit Board (PCB) of a mobile device, that minimises space on the PCB consumed by the shielding enclosure and increases the stiffness of the PCB.

Another aim of embodiments of the present invention is to provide a method for assembling a shielding system.

In accordance with a first aspect of the present invention there is provided a shielding system for a mobile device, the system comprising: a Printed Circuit Board, PCB; and a shield enclosure coupled to the PCB, and arranged to surround components on the front side of the PCB; wherein the shield enclosure is coupled to at least one of a lateral side and a back side of the PCB.

In accordance with a second aspect of the present invention there is provided a method for assembling a shielding system for a mobile device, the method comprising: providing a Printed Circuit Board, PCB; providing a shield enclosure that comprises a cover, above the PCB, and a fixing lead extending from the cover; and coupling the fixing lead to at least one of a lateral side and a back side of the PCB.

Other aspects, advantages, and salient features of the invention will become apparent to those skilled in the art from the following detailed description, which, taken in conjunction with the annexed drawings, discloses exemplary embodiments of the invention.

### BRIEF DESCRIPTION OF THE DRAWINGS

The above and other aspects, features, and advantages of certain exemplary embodiments of the present invention will be more apparent from the following description viewed in conjunction with the accompanying drawings, in which:

FIG. 1 illustrates a perspective view showing a shielding system according to a first exemplary embodiment of the present invention;

FIG. 2 illustrates a perspective view showing a shield enclosure of the shielding system shown in FIG. 1 according to an exemplary embodiment of the present invention;

FIG. 3 illustrates a perspective view showing the Printed Circuit Board (PCB) shown in FIG. 1 according to an exemplary embodiment of the present invention;

FIG. 4 illustrates a side view showing the shield enclosure shown in FIG. 1 along a lengthwise direction according to an exemplary embodiment of the present invention;

FIG. 5 illustrates a side view showing the shield enclosure shown in FIG. 1 along a widthwise direction according to an exemplary embodiment of the present invention;

FIG. 6 illustrates a top view showing the shield enclosure shown in FIG. 1 according to an exemplary embodiment of the present invention;

FIG. 7 illustrates a perspective view showing a shielding system according to a second exemplary embodiment of the present invention;

FIG. 8 illustrates a perspective view showing a shield enclosure of the shielding system shown in FIG. 7 according to an exemplary embodiment of the present invention;

FIG. 9 illustrates a perspective view showing a PCB shown in FIG. 7 according to an exemplary embodiment of the present invention;

FIG. 10 illustrates a side view showing the shield enclosure shown in FIG. 7 along a lengthwise direction according to an exemplary embodiment of the present invention;

FIG. 11 illustrates a side view showing the shield enclosure shown in FIG. 7 along a widthwise direction according to an exemplary embodiment of the present invention;

FIG. 12 illustrates a perspective view showing a shielding system according to a third exemplary embodiment of the present invention;

FIG. 13 illustrates a perspective view showing a shielding system according to a fourth exemplary embodiment of the present invention;

FIG. 14 illustrates a perspective view showing a modification of the shielding system shown in FIG. 13 according to an exemplary embodiment of the present invention;

FIG. 15 illustrates a perspective view showing a shielding system according to a fifth exemplary embodiment of the present invention; and

FIG. 16 illustrates a flowchart that describes a method for assembling a shielding system according to an exemplary embodiment of the present invention.

Throughout the drawings, it should be noted that like reference numbers are used to depict the same or similar elements, features, and structures

### DETAILED DESCRIPTION OF EXEMPLARY EMBODIMENTS

The following description with reference to the accompanying drawings is provided to assist in a comprehensive understanding of exemplary embodiments of the invention as defined by the claims and their equivalents. It includes various specific details to assist in that understanding but these are to be regarded as merely exemplary. Accordingly, those of ordinary skill in the art will recognize that various changes and modifications of the embodiments described herein can be made without departing from the scope of the invention as defined by the appended claims. In addition, descriptions of well-known functions and constructions may be omitted for clarity and conciseness.

The terms and words used in the following description and claims are not limited to the bibliographical meanings, but, are merely used by the inventor to enable a clear and consistent understanding of the invention. Accordingly, it should be apparent to those skilled in the art that the following description of exemplary embodiments of the present invention is provided for illustration purpose only and not for the purpose of limiting the invention as defined by the appended claims and their equivalents.

Throughout the description and claims of this specification, the words "comprise" and "contain" and variations of the words, for example "comprising" and "comprises", means "including but not limited to", and is not intended to (and does not) exclude other components, integers or steps.

It is to be understood that the singular forms "a," "an," and "the" include plural referents unless the context clearly dictates otherwise. Thus, for example, reference to "a component surface" includes reference to one or more of such surfaces.

Features, integers or characteristics described in conjunction with a particular aspect, embodiment or example of the invention are to be understood to be applicable to any other aspect, embodiment or example described herein unless incompatible therewith.

It will be also be appreciated that, throughout the description and claims of this specification, language in the general form of "X for Y" (where Y is some action, activity or step and X is some means for carrying out that action, activity or step) encompasses means X adapted or arranged specifically, but not exclusively, to do Y.

Detailed descriptions of well-known functions and structures incorporated herein may be omitted to avoid obscuring the subject matter of the invention.

Although the drawings represent exemplary embodiments of the present invention, the drawings are not necessarily to scale and certain features may be exaggerated or omitted in order to better illustrate and explain the invention.

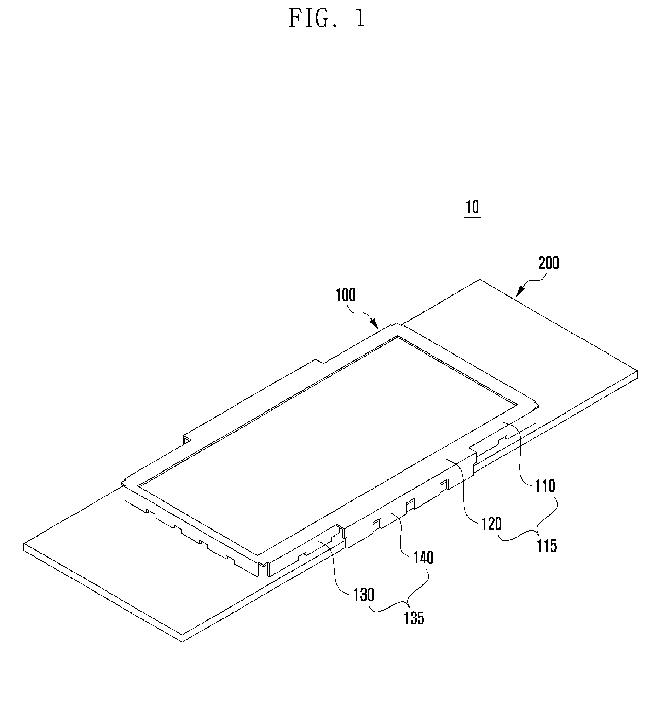

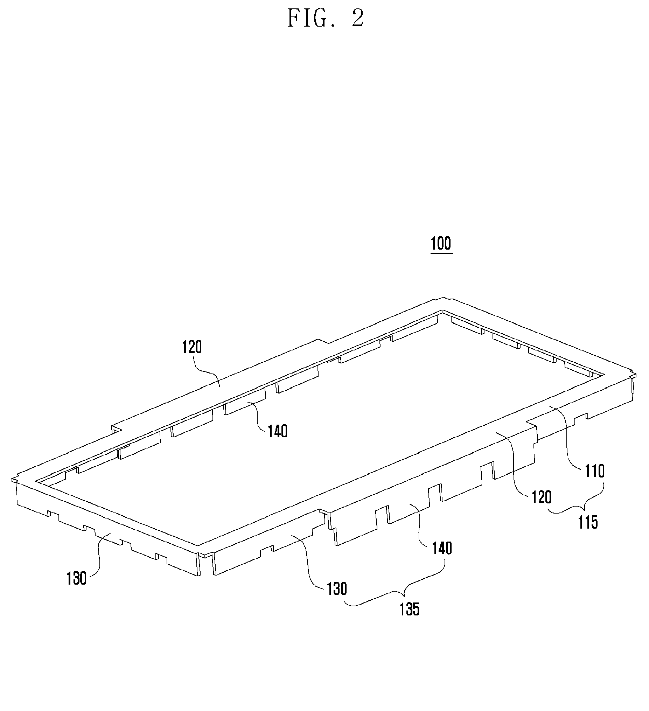

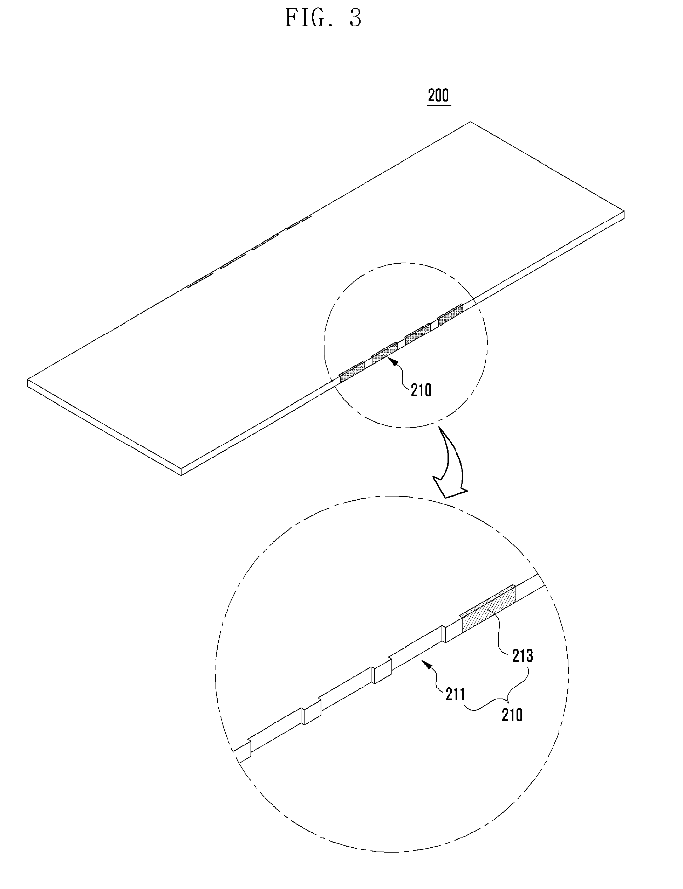

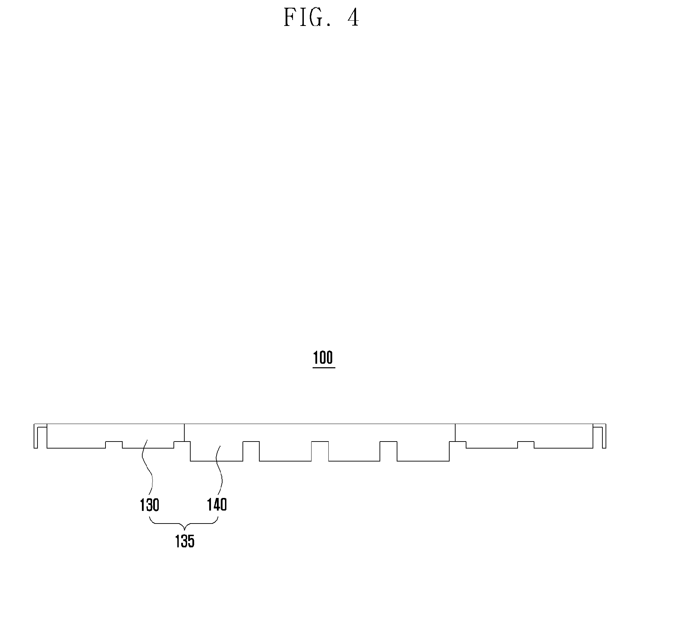

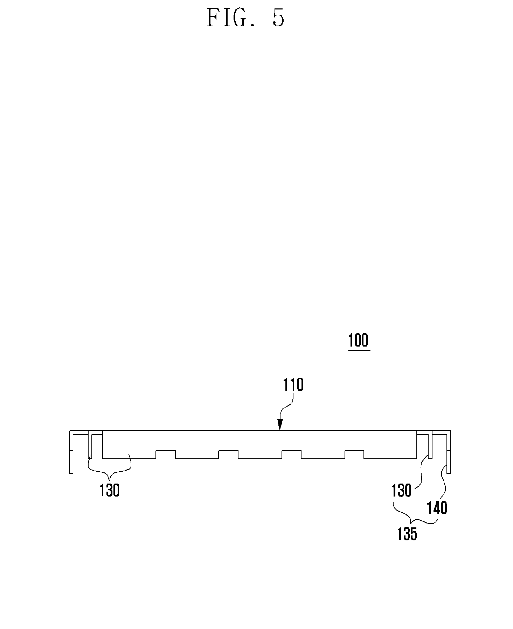

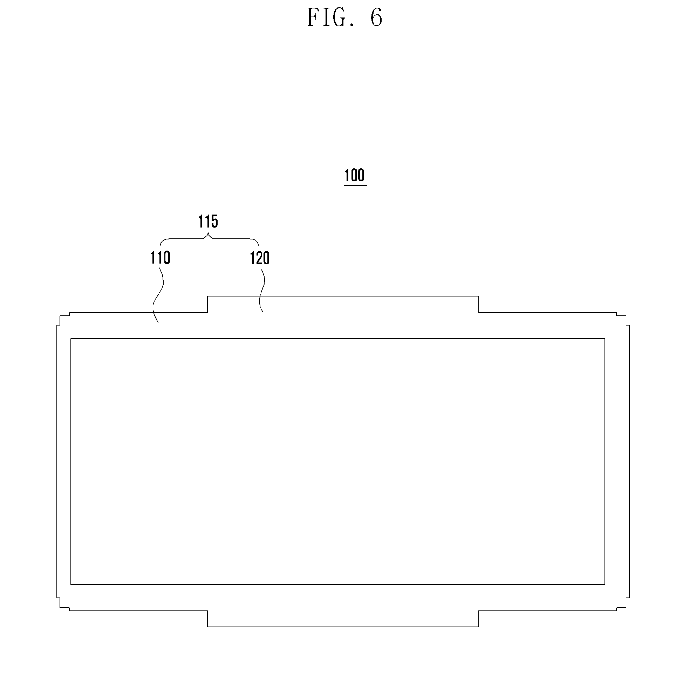

FIG. 1 illustrates a perspective view showing a shielding system according to a first exemplary embodiment of the present invention. FIG. 2 illustrates a perspective view showing a shield enclosure of the shielding system shown in FIG. 1 according to an exemplary embodiment of the present invention. FIG. 3 illustrates a perspective view showing a Printed Circuit Board (PCB) shown in FIG. 1 according to an exemplary embodiment of the present invention. FIG. 4 illustrates a side view showing the shield enclosure shown in FIG. 1 along a lengthwise direction according to an exemplary embodiment of the present invention. FIG. 5 illustrates a side view showing the shield enclosure shown in FIG. 1 along a widthwise direction according to an exemplary embodiment of the present invention. FIG. 6 illustrates a top view showing the shield enclosure shown in FIG. 1 according to an exemplary embodiment of the present invention.

Referring to FIGs. 1 to 6, the shielding system 10 includes a shield enclosure 100 and a PCB 200. The shielding system 10 is designed in such a way that fixing members of the shield enclosure 100 are coupled to the sides of the PCB 200. The design can tightly fix the shield enclosure 100 to the PCB 200 so that it can enclose components on the PCB, without requiring additional space from the PCB 200 in order to fix the shield enclosure 100 to the PCB. Therefore, the design allows the shield enclosure 100 to address the creation of noise from the components on the PCB 200 and also allows the shield enclosure 100 to provide stiffness to the PCB 200, thereby preventing the components on the PCB 200 from being damaged by an external impact, while minimising space requirements.

Referring to FIGs. 1 and 2, the shield enclosure 100 is designed in such a way that at least one contact lead 135 contacts at least a part of a side of the PCB 200 and a cover 115 encloses components on the PCB 200.

The cover 115 is shaped to enclose one or more edges of components on the PCB 200 and is made of a material for shielding noise, such as a conductive material, etc. For example, the cover 115 may be shaped as a band with a certain width. The cover 115 includes a band 110 which is generally rectangular according to the shape of the PCB 200 and at least one extension area 120 extended from at least one side of the band 110. Although the illustrated exemplary embodiment is implemented in such a way that the cover 115 is formed to be empty in the center portion, it should be understood that the invention is not limited thereto. For example, the cover 115 may be shaped as a continuous plate having no hole in the center portion, as a discontinuous plate having a plurality of holes, slots, or similar openings formed therein, and the like. As shown in FIG. 2, the cover 115 is implemented in such a way that a fundamental frame is formed as a band with a certain width along the edge and an extension frame is coupled to the fundamental frame to enclose the components in the PCB 200. The extension frame mitigates noise from components in the PCB 200 and provides stiffness to the PCB 200. It is preferable that the fundamental frame and the extension frame are made of a conductive material, e.g., a metal.

Each contact lead 135 is formed in such a way that it is extended from the side or edge of the cover 115 toward the PCB 200. The contact leads 135 include at least one fixing lead 140 for contacting the side of the PCB 200 to fix the shield enclosure 100 to the PCB, and at least one supporting lead 130 contacting a front side of the PCB 200 to support the shield enclosure 100 upon the front side of the PCB.

The supporting leads 130 include one or more walls extended from the cover 115. In an exemplary implementation, the supporting leads 130 may include one or more walls extended perpendicular to the cover 115. The supporting leads 130 support the shield enclosure 100 in such a way that ends of the supporting leads 130 contact the front side of the PCB 200. To this end, the PCB 200 may include grooves on the front side to receive the ends of the supporting lead 130, which will be described in greater detail later, referring to the accompanying drawings.

The fixing leads 140 extend from the edge of the cover 115 toward the PCB 200 and are long enough for end portions of the fixing leads 140 to contact the side of the PCB 200. The fixing leads 140 extend from the edge of the extension area 120 of the cover 115 toward the PCB 200 so that they can contact the side of the PCB 200 when the contact leads 135 are placed on the front side of the PCB 200. To this end, as shown in FIG. 2, the extension area 120 of the cover 115 has a greater width than the other part of the cover 115. Each fixing lead 140 extends from the edge of the extension area 120 toward the PCB 200, so that an end portion can contact the side of the PCB 200. The fixing leads 140 are longer than the supporting leads 130.

The or each extension area 120 extends from the edge of the band 110 toward the outside (i.e., an outer edge of the PCB) so that each fixing lead 140 extending toward the PCB 200 from an edge of an extension area 120 can contact the side of the PCB 200. Therefore, the width of the extension area 120 is the summation of the distance from a point where a supporting lead 130 is placed on the PCB 200 to the edge of the PCB 200 and the thickness of the fixing lead 140. As shown in FIG. 2, the extension areas 120 are formed on lengthwise sides of the cover 115. Therefore, the fixing leads 140 are also formed on lengthwise sides of the cover 115.

Although the illustrated exemplary embodiment is implemented in such a way that the fixing leads 140 are formed at both lengthwise sides of the cover 115 respectively, it should be understood that the invention is not limited thereto. That is, the fixing leads 140 and the extension areas 120 may be formed on one or more sides of the cover 115 shaped as a band, so that the fixing leads 140 can contact corresponding sides of the PCB 200. For example, if the PCB 200 is shaped as a rectangle, the fixing leads 140 may be formed in such a way that their number and their width are set by at least one of the four sides of the PCB 200 that the corresponding fixing leads will contact. In that case, the number of extension areas 120 is set according to the number of fixing leads 140. In an exemplary embodiment of the present invention, the fixing leads 140 are formed at both lengthwise sides of the cover 115, and the supporting leads 130 are formed around the periphery of the cover 115.

Referring to FIG. 3, the PCB 200 supports a number of hardware components for the mobile device and wires for transferring signals between components (not shown). The PCB 200 may also be implemented with a substrate onto which one or more copper sheets are laminated, forming multi-layers for space efficiency (not shown). The PCB 200 may include one or more contact areas 210 for contacting the or each fixing lead 140 of the shield enclosure 100 on one or more sides. The contact areas 210 are designed in such a way that a lead placement groove 211 extends into the PCB by a certain distance from the level of the PCB side surface. Furthermore, a soldering material 213 may be provided in the lead placement groove 211. The number and the shape of the lead placement grooves 211 correspond to the number and shape of the fixing leads 140. For example, as shown in FIGs. 1 to 3, if a fixing lead 140 is formed with four sidewalls extending perpendicularly from the edge of an extension area 120 of the cover 115, the PCB 200 may be provided with four lead placement grooves 211 at corresponding locations on the side of the PCB. Each of the four lead placement grooves 211 may also be filled with soldering material 213. The four side walls of the fixing lead 140 of the shield enclosure 100 are arranged corresponding to and in contact with the lead placement grooves 211. The four side walls of the fixing lead 140 of the shield enclosure 100 may then be coupled to the soldering materials 213 therein via a reflow process. In order to place soldering material 213 into a lead placement groove 211, a pad on which soldering material is deposited may be applied to the lead placement groove 211. Of course, this is merely an example and soldering material 213 may be placed into the grooves 211 using any of a plurality of methods.

As described above, the shield enclosure 100 is coupled to the PCB 200 in such a way that each fixing lead 140 contacts and is fixed to the side of the PCB 200. In this manner, the PCB 200 does not require a fixing space to adhere the shield enclosure 100 thereto, thus enabling the PCB 200 to be made smaller. Moreover, if hardware components need to be arranged on the front side of the PCB 200, the exemplary shielding system 10 can provide enough space to stably arrange them. In addition, since each fixing lead 140 of the shield enclosure 100 is tightly fixed to the soldering material 213 of the PCB 200 via a soldering process, the shield enclosure 100 can be permanently coupled to the PCB 200 which provides stiffness to the PCB 200. Therefore, the exemplary shielding system 10 can prevent damage to and therefore increase the reliability of hardware components mounted on the PCB 200.

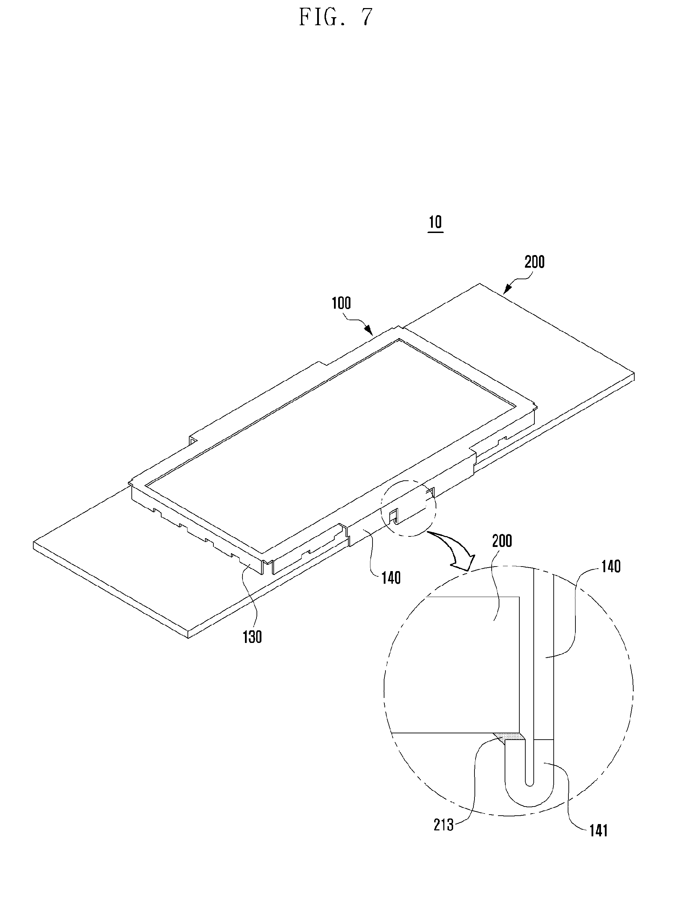

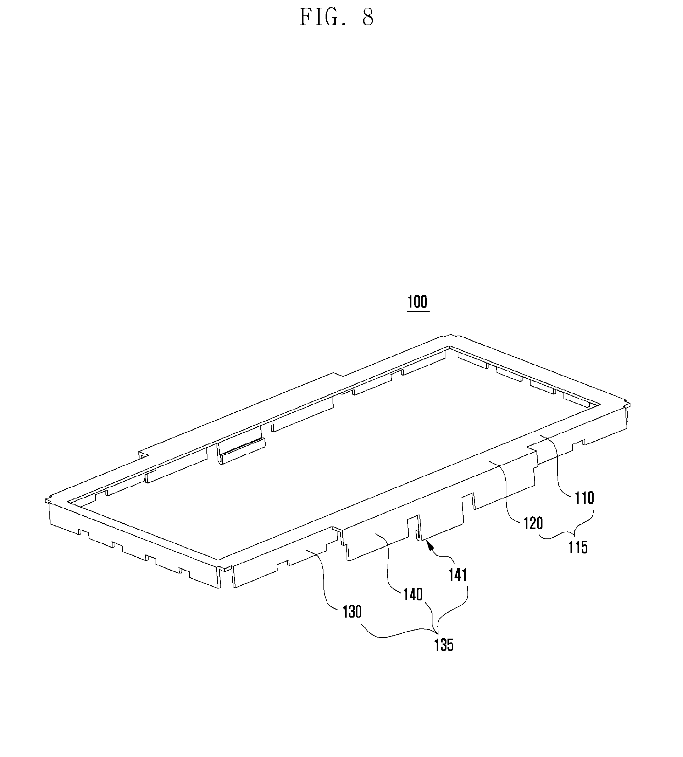

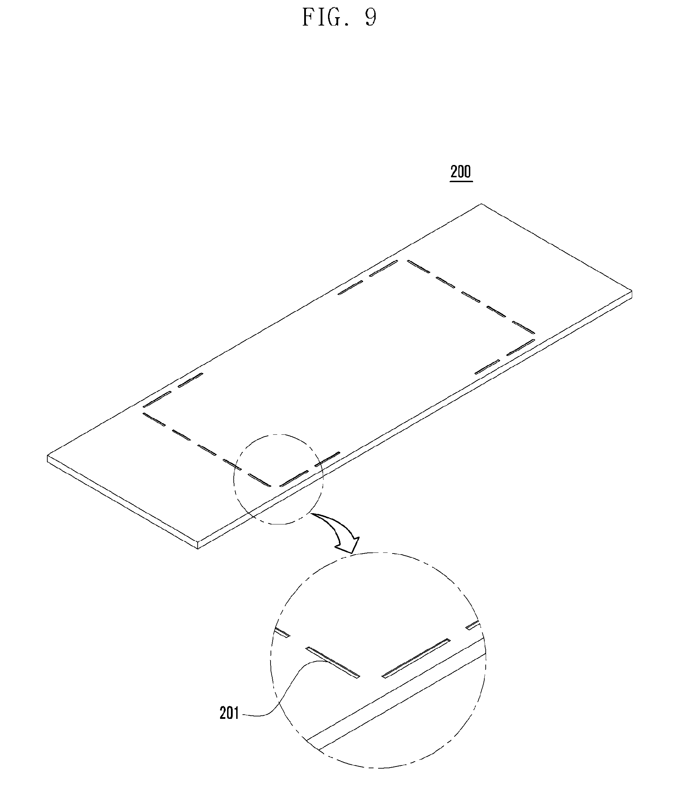

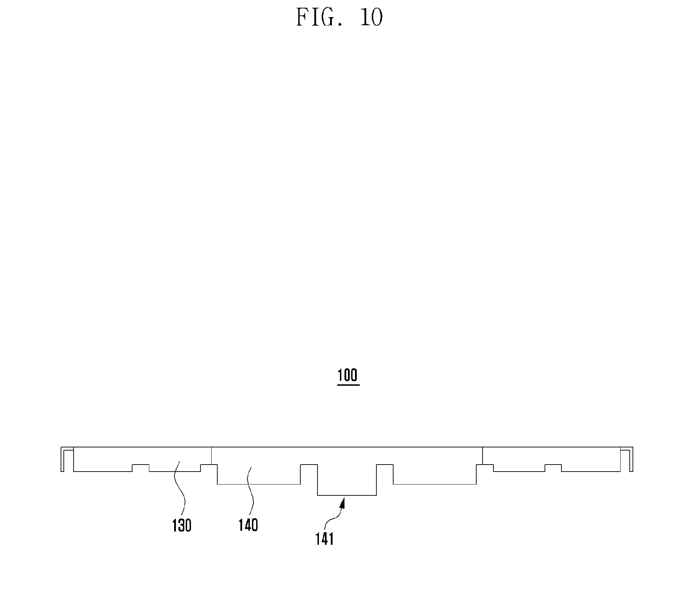

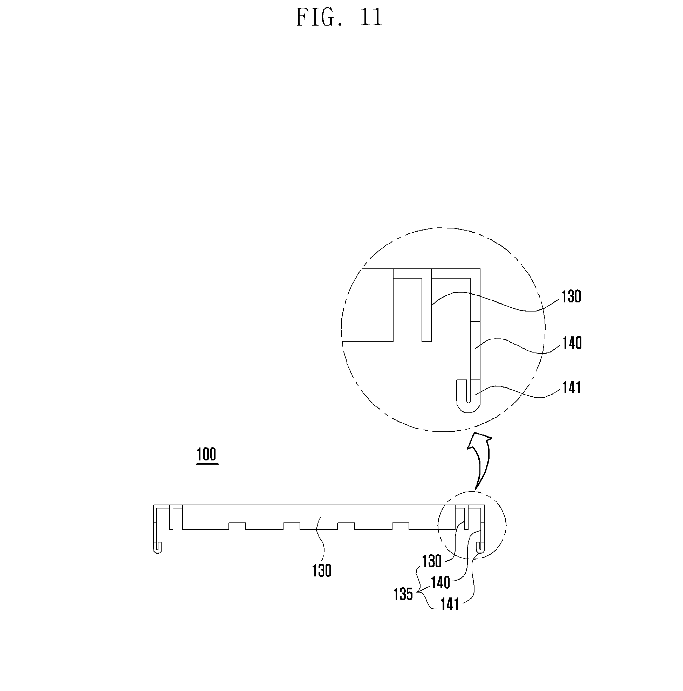

FIG. 7 illustrates a perspective view showing a shielding system according to a second exemplary embodiment of the present invention. FIG. 8 illustrates a perspective view showing a shield enclosure of the shielding system shown in FIG. 7 according to an exemplary embodiment of the present invention. FIG. 9 illustrates a perspective view showing a PCB shown in FIG. 7 according to an exemplary embodiment of the present invention. FIG. 10 illustrates a side view showing the shield enclosure shown in FIG. 7 along a lengthwise direction according to an exemplary embodiment of the present invention. FIG. 11 illustrates a side view showing the shield enclosure shown in FIG. 7 along a widthwise direction according to an exemplary embodiment of the present invention.

Referring to FIGs. 7 to 11, the shielding system 10 includes a shield enclosure 100 and a PCB 200.

The shield enclosure 100 includes at least one fixing lead 140 having a hook 141 formed at the end. The shield enclosure 100 is coupled to the PCB 200 in such a way that, when each fixing lead 140 contacts the side of the PCB 200, the hook 141 hooks the back side of the PCB 200. That is, the shield enclosure 100 can be fixed to the PCB 200 in such a way that the hook 141 of each fixing lead 140 is fixed to the sides and/or the back side of the PCB 200. As such, the shielding system 10 does not need an additional space in the front side of the PCB 200 for affixing the shield enclosure 100 and allows the shield enclosure 100 to enclose the components on the PCB 200. The design allows the shield enclosure 100 to mitigate noise from the components on the PCB 200. The design can also allow the shield enclosure 100 to provide stiffness to the PCB 200, thereby preventing the components on the PCB 200 from being damaged by an external impact. In an exemplary embodiment of the present invention, the hook 141 may be formed as an extension from the end of the fixing lead 140.

Referring to FIGs. 7 and 8, the shield enclosure 100 is designed in such a way that at least one contact lead 135 contacts the side (e.g., a lateral side) or/and the back side of the PCB 200 and a cover 115 encloses components on the PCB 200.

The cover 115 is shaped to enclose one or more edges of the components on the PCB 200. For example, the cover 115 may be shaped as a plate with a certain area or as a band with a certain width. The cover 115 may be shaped according to the shape of the PCB 200. In an exemplary embodiment of the present invention as shown in FIG. 8, although the cover 115 is formed to be empty in the center portion, it should be understood that the invention is not limited thereto. For example, the cover 115 may be shaped as a continuous plate having no hole in the center portion, as a discontinuous plate having a plurality of holes, slots, or similar opening formed therein, and the like. As shown in FIG. 8, the cover 115 may be implemented in such a way that a fundamental frame is formed as a band with a certain width along the edge, and an extension frame is coupled to the fundamental frame to enclose the components in the PCB 200. The extension frame mitigates noise from components of the PCB 200 and provides stiffness to the PCB 200. To this end, the fundamental frame may include a structure to be coupled to the extension frame, and, likewise, the extension frame may also include the corresponding structure to be coupled to the fundamental frame.

The contact leads 135 includes side walls that extend from the side or edge of the cover 115 toward the PCB 200. That is, the contact leads 135 include at least one fixing lead 140 for contacting the side (e.g., a lateral side) or the back side of the PCB 200 to fix the shield enclosure 100 thereto, and at least one supporting lead 130 contacting the front side of the PCB 200 to support the shield enclosure 100 upon the front side of the PCB 200.

Each supporting lead 130 includes one or more walls extended from the cover 115. In an exemplary implementation, each supporting lead 130 may include one or more walls which extend perpendicular to the cover 115. Each supporting lead 130 supports the shield enclosure 100 in such a way that ends of the supporting lead 130 contact the front side of the PCB 200. The PCB 200 may include grooves 201 on the front side to receive the ends of the supporting leads 130 as shown in FIG. 9.

Referring to FIG. 9, the grooves 201 are located on the front side of the PCB 200 at the corresponding locations where the supporting leads 130 are placed. Each of the grooves 201 may be formed having a depth that does not affect any circuit pattern formed in the substrate of the PCB 200, e.g., 0.1 mm. Although an exemplary embodiment of the present invention is implemented in such a way that the grooves 201 are located towards the top and bottom of the front side of the PCB 200 so as to form approximately the shape of square or angled brackets '[' and ']', it should be understood that the invention is not limited thereto. The number of grooves 201 may be one or more. The grooves 201 are formed on the front side of the PCB 200 and receive the side walls of each supporting lead 130, extending from the edge of the cover 115 toward the PCB 200. Parts of the side walls of each supporting lead 130, received by the grooves 201, are longer than the remaining side walls that are not inserted into the grooves 201 by the depth of the groove 201. In an exemplary implementation, if the grooves 201 are designed to receive the ends of the entire side wall of each supporting lead 130, each supporting lead 130 may be formed so that the side walls have the same length.

Each fixing lead 140 extends from the edge of the cover 115 toward the PCB 200 so that end portions of the fixing leads 140 can contact the side and the back side of the PCB 200. That is, each fixing lead 140 extends from the edge of the extension area 120 of the cover 115 toward the PCB 200 so that it can contact the side or the back side of the PCB 200 when the contact lead 135 is placed on the front side of the PCB 200. To this end, the cover 115 shaped as a band may include one or more extension areas 120, each of which has a greater area than the other parts. Each fixing lead 140 is shaped in such a way that it extends from the edge of the extension area 120 toward the PCB 200, contacting the side of the PCB 200, and extending to the back side of the PCB 200. Therefore, the fixing lead 140 has a greater length than the supporting lead 130, by the summation of the thickness of the PCB 200 and the length of the hook 141 overlapping the back side of the PCB 200 as shown in FIG. 11. As described above, each fixing lead 140 comprises a hook 141 at the end. As shown in FIG. 11, the hook 141 extends from the end of the fixing lead 140, past the back side of the PCB 200, and is configured so that the end contacts the back side of the PCB 200. In an exemplary implementation, the end of the hook 141 can be soldered to the back side of the PCB 200, thereby fixing the shield enclosure 100 to the PCB 200. To this end, the PCB 200 may include a soldering pad 213 on the back side, thereby soldering the hook 141 thereto, for example via a reflow process.

The extension area 120 extends from the edge of the band 110 toward the outside so that each fixing lead 140 extending toward the PCB 200 from the edge of the extension area 120 can contact the side of the PCB 200. Therefore, the width of the extension area 120 is the summation of the distance from a point where the supporting lead 130 is placed on the PCB 200 to the edge of the PCB 200 and the thickness of a fixing lead 140. The extension areas 120 are formed on lengthwise sides of the cover 115. Therefore, the fixing leads 140 are also formed on lengthwise sides of the cover 115.

Although an exemplary embodiment of the present invention is implemented in such a way that fixing leads 140 with hooks 141 are formed along lengthwise sides of the cover 115, it should be understood that the invention is not limited thereto. That is, the fixing leads 140 and the extension areas 120 may be formed along one or more sides of the cover 115 shaped as a band, so that the fixing leads 140 can contact corresponding sides and the back side of the PCB 200. For example, if the PCB 200 is shaped as a rectangle, fixing leads 140 may be formed in such a way that their number and their width are set by at least one of the four sides of the PCB 200 and the back side of the PCB 200 that the corresponding fixing leads will contact. In that case, the number of extension area 120 is set according to the number of fixing leads 140. In an exemplary embodiment of the present invention, the fixing leads 140 are formed along lengthwise sides of the cover 115, and the supporting leads 130 are formed in the widthwise direction of the cover 115.

The PCB 200 may be designed in substantially the same configuration as the first exemplary embodiment of the present invention shown in FIGs. 1 to 6, except that the PCB 200 of the second exemplary embodiment includes grooves 201 for receiving the supporting leads 130 on the front side. That is, the PCB 200 may be implemented with a substrate onto which one or more copper sheets are laminated, forming multi-layers for space efficiency. The PCB 200 may form at least one contact area 210 for contacting the fixing leads 140 of the shield enclosure 100 on one or more sides. The contact areas 210 may be designed in such a way that lead placement grooves 211 extend into the PCB by a certain distance from the side surface of the PCB. The number and the shape of the lead placement grooves 211 correspond to those of the fixing leads 140. For example, if the fixing leads 140 are formed with four sidewalls perpendicularly extended from the edge of the extension area 120 of the cover 115, the PCB 200 may form four lead placement grooves 211 at the corresponding locations on the side of the PCB. The hook 141 formed at the end of each fixing lead 140 contacts the back side of the PCB 200.

Although the second exemplary embodiment of the present invention is implemented in such a way that each lead placement groove 211 is formed on the side of the PCB 200, it should be understood that the invention is not limited thereto. That is, the second exemplary embodiment of the present invention may be modified in such a way that the PCB 200 does not form lead placement grooves 211 on the side and the hook 141 located at the end of each fixing lead 140 is soldered onto the back side of the PCB 200. To this end, the PCB 200 may include a pad with a soldering material 213 at the corresponding location on the back side where the hook 141 will be placed. In that case, when the shield enclosure 100 is coupled to the PCB 200, the hook 141 can be soldered to a pad on the back side of the PCB 200, for example via a reflow process.

As described above, an exemplary shield enclosure 100 is coupled to the PCB 200 in such a way that fixing leads 140 contact the side of the PCB 200 and hooks 141 of the fixing leads 140 are fixed to the back side of the PCB 200. This can provide enough space to stably arrange hardware components on the PCB 200, without consuming front space on the PCB 200. In addition, this can tightly fix the shield enclosure 100 to the PCB 200.

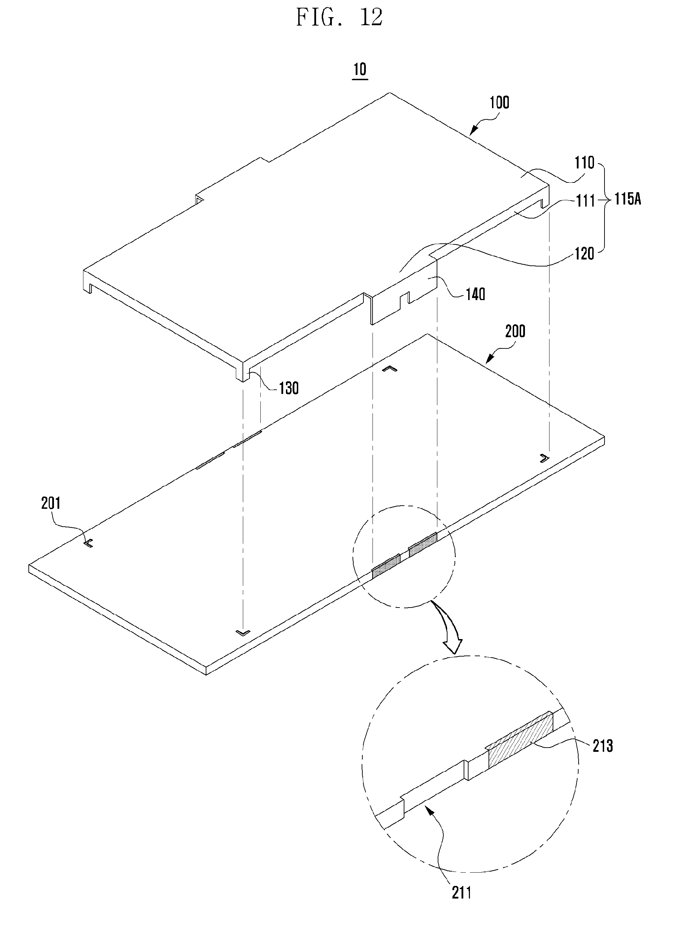

FIG. 12 illustrates a perspective view showing a shielding system according to a third exemplary embodiment of the present invention.

Referring to FIG. 12, a shielding system 10 is implemented in such a way that a cover 115A forms a front side of the shield enclosure 100, support leads 130 are formed at the corners of the cover 115A, and fixing leads 140 are formed in extension areas 120 of the cover 115A.

The cover 115A includes an enclosing part 110 with an area for covering at least part of the front side of the PCB and side walls 111 each of which extends from an edge of the enclosing part 110 so that it has a certain area. In an exemplary implementation, the sidewalls 111 may include one or more walls extended perpendicular from edges of the enclosing part 110. At least one part of a side wall 111 may be replaced with an extension area 120 extending toward the outside (e.g., an external edge) of the enclosing part 110, to have a certain area, with a fixing lead 140 extending from the edge of the extension area 120. In an exemplary implementation, the fixing leads 140 may extend perpendicularly from the edge of the extension area 120. The fixing leads 140 extend further than the side wall 111 toward the PCB 200 and contact the side of the PCB 200.

The supporting leads 130 extend further than the side walls 111, however they extend less far than the fixing leads 140. The supporting leads 130 are placed into grooves 201 formed on the PCB 200.

As described above, since the shield enclosure 100 is coupled to the PCB 200 in such a way that the cover 115A forms, at certain portions, e.g., corners, the supporting leads 130 to be placed into the grooves 201 of the PCB 200. The fixing leads 140 of the extension areas 120 extend from the cover 115A contact the sides of the PCB 200 and are fixed thereto, for example via a soldering process and a reflow process. The shield enclosure can provide stiffness to the PCB 200. In addition, since the third exemplary embodiment of the shielding system 10 forms an optimum number of grooves 201 on the PCB 200, it can simplify the manufacturing process of the PCB 200.

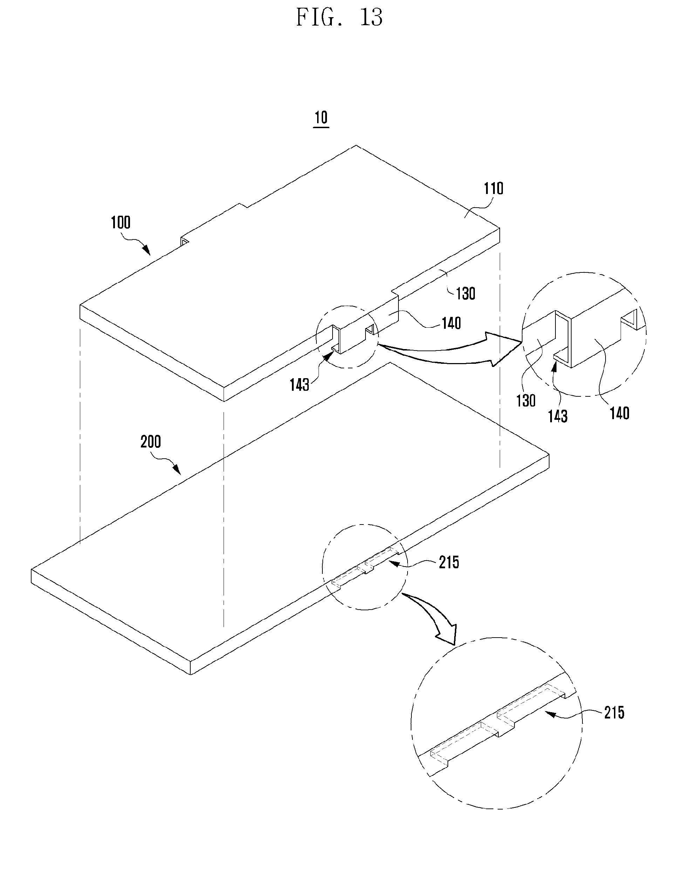

FIG. 13 illustrates a perspective view showing a shielding system according to a fourth exemplary embodiment of the present invention.

Referring to FIG. 13, a shield enclosure 100 of the fourth exemplary embodiment of the present invention is designed with similar components to those shown in FIGs. 7 to 11. However, the shield enclosure 100 of the fourth exemplary embodiment includes bent parts 143 instead of hooks 141. The bent parts 143 extend from the end of the fixing leads 140 toward the PCB 200, so that they can contact the back side of the PCB 200. In an exemplary implementation, the bent parts 143 may extend perpendicularly from the end of the fixing lead 140. The PCB 200 includes locking grooves 215 to receive the bent parts 143 at the corresponding locations on the back side. The locking grooves 215 may guide the bent parts 143 for ease of placement of the bent parts 143. In an exemplary implementation, the locking grooves 215 may include soldering materials. In that case, the bent parts 143 can be tightly fixed to the locking grooves 215 via the soldering materials, for example by a reflow process. The bent parts 143 may also be formed in such way that the fixing leads 140 are extended.

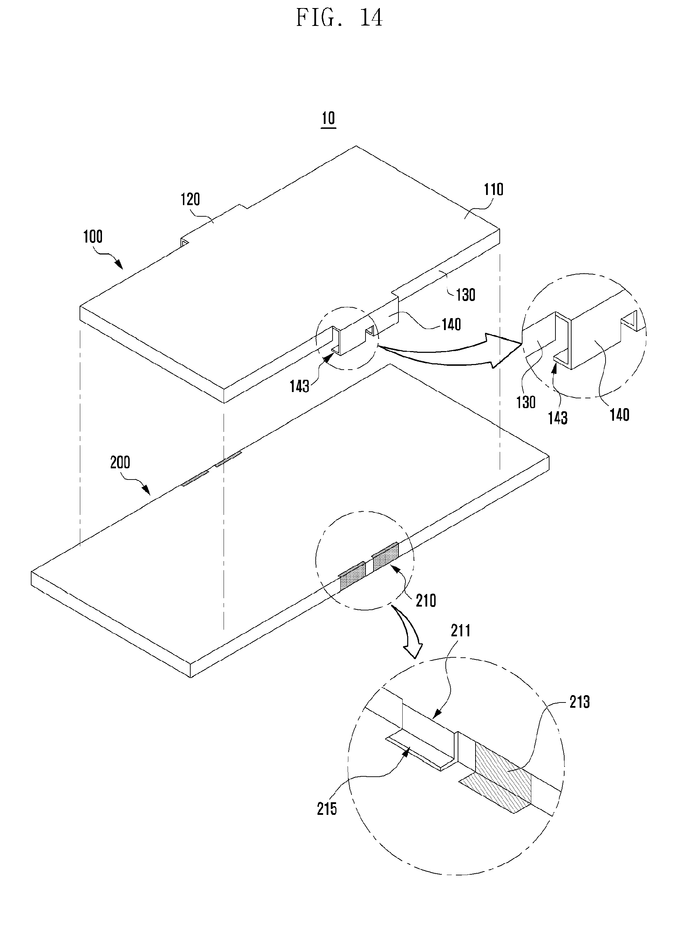

FIG. 14 illustrates a perspective view showing a modification of the shielding system shown in FIG. 13 according to an exemplary embodiment of the present invention.

Referring to FIG. 14, the fourth exemplary embodiment of shielding system 10 may be modified in such a way that the PCB 200 includes a lead placement groove 211 on the side and a locking groove 215 on the back surface, where the lead placement groove 211 and the locking grooves 215 are placed side by side. In addition, each extension area 120 may include a fixing lead 140 and a bent part 143, where the fixing lead 140 is fixed to the lead placement groove 211 and the bent part 143 is fixedly received by the locking groove 215. The lead placement groove 211 and the locking groove 215 can be coupled to the fixing lead 140 and the bent pat 143, for example via soldering material and reflow processes, respectively. The PCB 200 may include a soldering pad on the surface in order to protect the grooves formed thereon and to locate the soldering material therein. The soldering pad may be implemented with a metal plate shaped as a thin film.

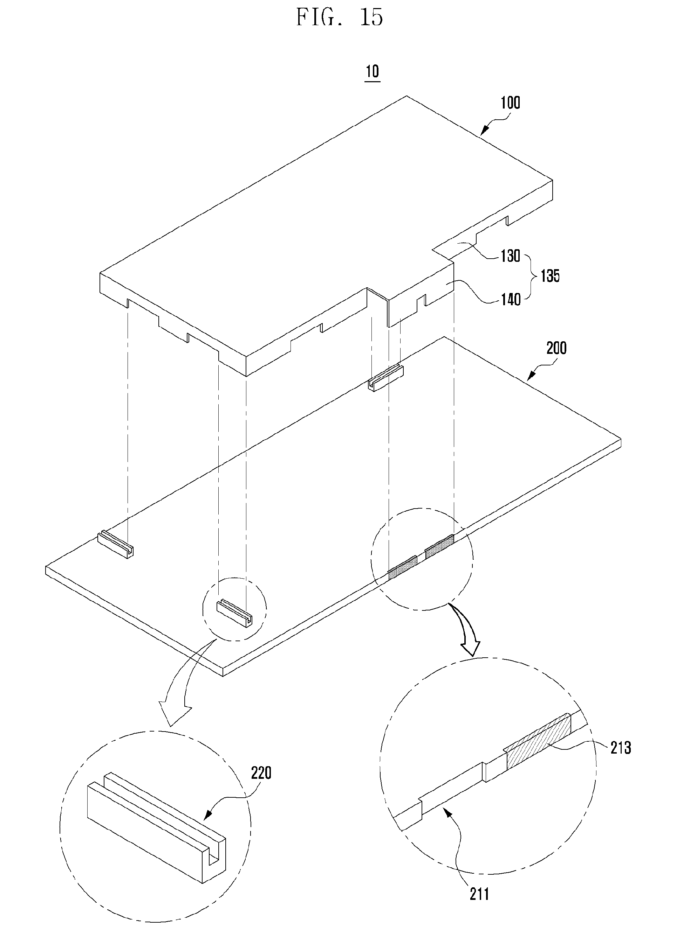

FIG. 15 illustrates a perspective view showing a shielding system according to a fifth exemplary embodiment of the present invention.

Referring to FIG. 15, the shielding system 10 is designed in such a way that the shield enclosure 100 includes at least one contact lead 135. Each contact lead 135 is coupled to PCB 200 in such a way that at least one contact lead 135 is inserted to a slot unit 220 located on the PCB 200, and at least one contact lead 135 is fixed to the lead placement groove 211 located on the side (e.g., a lateral side) and/or the back side of the PCB 200. The slot units 220 may be fixed onto the front side of the PCB 200, for example via a soldering material and a reflow process. The contact leads 135 may be fitted into the slot unit 220 and separated therefrom by applying an external force to the contact lead 135. The shield enclosure 100 of the fifth exemplary embodiment of the present invention may be applied to PCBs having restricted use of their sides, so that it can still provide stiffness to the PCBs.

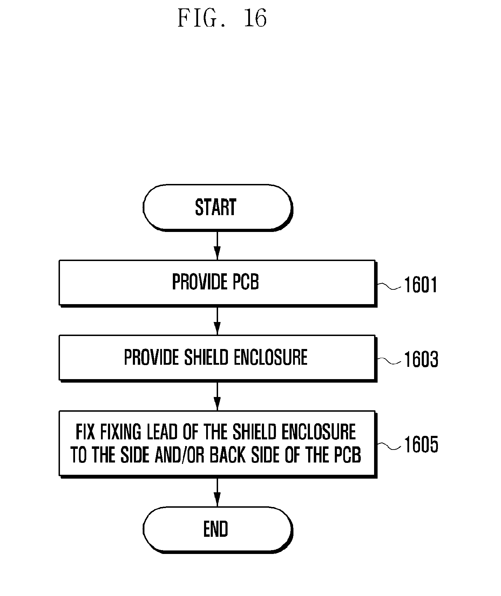

FIG. 16 illustrates a flowchart that describes a method for assembling the shielding system 10 according to an exemplary embodiment of the present invention.

Referring to FIG. 16, a PCB 200 is provided in step 1601. A shield enclosure 100 with a cover, located above the PCB 200, and at least one fixing lead extending from the cover, is provided in step 1603. Each fixing lead of the shield enclosure 100 is fixed to the side and/or the back surface of the PCB 200 in step 1605. As described above, the exemplary assembly method can easily couple the shield enclosure 100 to the PCB 200, so that the shield enclosure 100 can provide stiffness to the PCB 200.

The fixation of the shield enclosure 100 to the side and/or the back surface of the PCB may include forming a lead placement groove, formed on the side of the PCB at a location corresponding to the fixing lead, and/or on the back surface of the PCB at a location corresponding to a bent part formed at an end of a fixing lead. A pad with soldering material is placed in the lead placement groove. The shield enclosure with the fixing lead is brought into position such that a fixing lead or a bent part is in contact with the lead placement groove. The fixing lead or the bent part is secured to the lead placement groove via a reflow process.

The fixing leads may include a hook, or a bent part. The fixing lead extends from the cover and may perpendicularly extend from the cover. A hook may be formed at the end of the fixing lead in such a way that it is bent toward the back side of the PCB and contacts the back side of the PCB. A bent part may be formed at the end of the fixing lead in such a way that it is bent toward the back side of the PCB, perpendicular to the fixing lead.

In an exemplary implementation, the method for assembling the shielding system may further include forming one or more grooves each of which has a certain depth and an area on the front side of the PCB, and placing supporting leads, extending parallel to the fixing lead and perpendicular to the cover of the shield enclosure 100, into the grooves. The exemplary method for assembling the shielding system may further include placing one or more slot units on the front side of the PCB, and fitting supporting leads, extending parallel to the fixing lead and perpendicular to the cover of the shield enclosure 100, into the slot units via an external force.

As described above, since the shielding system 10 is designed in such a way that the shield enclosure 100 comprises one or more fixing leads 140 that are fixed to one or more sides of the PCB 200 to tightly couple the shield enclosure 100 to the PCB 200 and thus provide reliability in operation. In addition, the PCB of the shielding system 10 can be designed to use a combination of part of the side and slot units or screws, considering the shape of the PCB or the space area of the PCB where electric components are mounted, thereby providing extension for coupling shield enclosures to PCBs.

As described above, the shielding system and the method for assembling the system, according to exemplary embodiments of the present invention, can tightly fix the shield enclosure to the PCB, providing a proper coupling space area where components will be installed, and can reduce the size of mobile devices. The shielding system and the method for assembling the system can increase the stiffness of a PCB via the shield enclosure.

The shielding system according to exemplary embodiments of the present invention can be applied to mobile devices. Here, the term mobile device includes any information communication devices, multimedia devices, and their applications, which are operated according to communication protocols corresponding to various types of communication systems. For example, the mobile device can be applied to mobile communication terminals, Portable Multimedia Players (PMPs), digital broadcast players, Personal Digital Assistants (PDAs), audio players (e.g., MP3 players), mobile game players, smartphones, laptop computers, hand-held PC, etc.

While the invention has been shown and described with reference to certain exemplary embodiments thereof, it will be understood by those skilled in the art that various changes in form and details may be made therein without departing from the scope of the invention as defined by appended claims.

## Claims

1. A shielding system for a mobile device, the system comprising:
a Printed Circuit Board, PCB; and
a shield enclosure coupled to the PCB, and arranged to surround components on the front side of the PCB;
wherein the shield enclosure is coupled to at least one of a lateral side and a back side of the PCB.

2. The system of claim 1, wherein the shield enclosure comprises:
a cover;
a supporting lead arranged to contact the front side of the PCB, wherein the supporting lead comprises a side wall extending from an edge of the cover; and
a fixing lead extending from the edge of the cover and arranged to contact and be fixed to at least one of the lateral side and the back side of the PCB.

3. The system of claim 2, wherein the PCB further comprises one or more grooves, formed on the front side of the PCB, arranged to receive the supporting lead.

4. The system of claim 2 or claim 3, wherein the PCB further comprises one or more lead placement grooves, formed on the lateral side of the PCB, arranged to receive the fixing lead.

5. The system of claim 4, further comprising:
a soldering pad, located in at least one lead placement groove, and arranged to couple the fixing lead to the lead placement groove via a reflow process.

6. The system of any one of claims 2 to 5, further comprising:
a hook located at an end of the fixing lead and bent towards the back side of the PCB; or
a bent part located at an end of the fixing lead and bent toward the back side of the PCB perpendicular to the fixing lead.

7. The system of claim 6, further comprising:
a soldering pad on the back side of the PCB at a point where the hook approaches the back side of the PCB, arranged to couple the hook to the back side of the PCB via a reflow process.

8. The system of claim 6 or claim 7, further comprising:
a locking groove, formed on the back side of the PCB, arranged to receive the bent part.

9. The system of claim 8, further comprising:
a soldering pad, located in the locking groove, arranged to couple the bent part to the locking groove via a reflow process.

10. The system of claim 2, further comprising:
a slot unit, located on the front side of the PCB, arranged to receive the supporting lead.

11. A method for assembling a shielding system for a mobile device, the method comprising:
providing a Printed Circuit Board, PCB;
providing a shield enclosure that comprises a cover, above the PCB, and a fixing lead extending from the cover; and
coupling the fixing lead to at least one of a lateral side and a back side of the PCB.

12. The method of claim 11, wherein coupling the fixing lead to at least one of a lateral side and a back side of the PCB comprises:
forming at least one of a lead placement groove on the lateral side of the PCB at a location corresponding to the fixing lead;
forming a bent part at the end of the fixing lead bent toward the back side of the PCB;
placing a pad with a soldering material in the lead placement groove or on the back side of the PCB at a location corresponding to the bent part;
positioning the shield enclosure on the PCB such that the fixing lead is in contact with the lead placement groove or the bent part is in contact with the location on the back side of the PCB corresponding to the bent part; and
coupling the fixing lead to the lead placement groove or the bent part to the location on the back side of the PCB corresponding to the bent part via a reflow process.

13. The method of claim 11 or claim 12, wherein providing a shield enclosure comprises at least one of the following:
forming a fixing lead extending perpendicularly from the cover;
forming a hook at the end of the fixing lead bent toward the back side of the PCB and to contact the back side of the PCB; and
forming a bent part at the end of the fixing lead bent toward the back side of the PCB, perpendicular to the fixing lead.

14. The method of any one of claims 11 to 13, further comprising:
forming one or more grooves on a front side of the PCB; and
placing supporting leads, extending parallel to the fixing lead and perpendicular to the cover, into the grooves.

15. The method of any one of claims 11 to 13, further comprising:
placing one or more slot units on a front side of the PCB; and
fitting supporting leads, extending parallel to the fixing lead and perpendicular to the cover, into the slot units by applying an external force.
